# Europäisches Patentamt
# European Patent Office
# Office européen des brevets

(19)

(11) Veröffentlichungsnummer: **0 143 378**
**B1**

(12) **EUROPÄISCHE PATENTSCHRIFT**

(45) Veröffentlichungstag der Patentschrift:
**06.04.88**

(51) Int. Cl.⁴: **G 01 R 33/06**, G 05 F 1/66

(21) Anmeldenummer: **84113515.5**

(22) Anmeldetag: **09.11.84**

(54) **Verfahren und Vorrichtung zum Stabilisieren des Arbeitspunktes eines Hallkristalls.**

(30) Priorität: **25.11.83 DE 3342603**

(43) Veröffentlichungstag der Anmeldung:
**05.06.85 Patentblatt 85/23**

(45) Bekanntmachung des Hinweises auf die Patenterteilung:
**06.04.88 Patentblatt 88/14**

(84) Benannte Vertragsstaaten:
**CH FR GB IT LI**

(56) Entgegenhaltungen:
**DE-A-1 616 456**

**A.T.M.; ARCHIV FÜR TECHNISCHES MESSEN
UND INDUSTRIELLE MESSTECHNIK, Blatt V 391-11,
Nr.439, August 1972, Seiten 141-142, München, DE;
K.W.BONFIG et al.: "Anwendung des
Hallgenerators zur Vermessung von
Magnetfeldern"**

(73) Patentinhaber: **Bruker Analytische Messtechnik
GmbH, Silberstreifen, D-7512 Rheinstetten-
Forchheim (DE)**

(72) Erfinder: **Biehl, Reinhard, Dr., Reinhold- Schneider-
Strasse 123, D-7500 Karlsruhe 51 (DE)**

(74) Vertreter: **Patentanwälte Kohler - Schwindling -
Späth, Hohentwielstrasse 41, D-7000 Stuttgart 1
(DE)**

## Beschreibung

Die Erfindung bezieht sich auf ein Verfahren und eine Vorrichtung zum Stabilisieren des Arbeitspunktes eines in einem Magnetfeld variabler Stärke befindlichen und aus einer Versorgungsquelle mit elektrischer Energie versorgten Hallkristalls, bei dem der Hallkristall über einen Vorwiderstand aus einer Konstantspannungsquelle versorgt und die Verlustleistung des Hallkristalls ermittelt und stabilisiert wird.

Ein derartiges Verfahren und eine derartige Vorrichtung sind der DE-Z A.T.M.; Archiv für technisches Messen und industrielle Meßtechnik 11 (August 1972), Seite 141 bis 142, bekannt.

Es ist bekannt, zum Messen und Regeln magnetischer Felder Sonden zu verwenden, die einen Hallkristall enthalten. Bekanntlich wird dabei an einen Hallkristall senkrecht zur Richtung des Magnetfeldes eine Spannung angelegt bzw. ein Strom eingespeist, so daß Ladungsträger durch den Hallkristall in Richtung der angelegten Spannung driften. Diese Ladungsträger werden aufgrund des herrschenden magnetischen Feldes in einer Ebene senkrecht zum Feld abgelenkt, so daß man eine sog. Hallspannung senkrecht zur anliegenden Spannung und senkrecht zum magnetischen Feld abnehmen kann, die ein Maß für die Stärke des magnetischen Feldes ist.

Es ist weiter bekannt, daß sich der Wert des Innenwiderstandes des Hallkristalls mit der Stärke des magnetischen Feldes ändert, typischerweise überproportional zunehmend mit der Stärke des Magnetfeldes. Dieg bedeutet, daß bei Einspeisung eines stabilisierten Stromes in den Hallkristall die Verlustleistung im Hallkristall bei zunehmendem Feld zunimmt und bei anliegender konstanter Spannung am Hallkristall abnimmt.

Verwendet man einen Hallkristall zur Regelung und Stabilisierung eines Magnetfeldes bei Elektronenspinresonanz-Spektrometern, muß die Regelung so ausgelegt sein, daß ein Feldbereich von beispielsweise 0 big 2,5 Tesla noch zufriedenstellend überstrichen werden kann. Übliche Hallkristalle, deren Geometrie auf optimale Feldlinearität über diesen genannten Betriebsbereich ausgelegt ist, weisen jedoch einen über diesen Betriebsbereich um einen Faktor 2 und darüber variierenden Innenwiderstand auf.

Dies bedeutet, daß beim Durchlaufen dieses Betriebsbereiches und einer Konstantstromregelung die Verlustleistung um über 100 % zunimmt und bei einer Konstantspannungsregelung um etwa 50 % abnimmt.

Eine derartige Variation der Sondenverlustleistung führt jedoch zwangsläufig zu Temperaturänderungen des Hallkristalls. Damit kann sich die Kurzzeitstabilität einer solchen Anordnung, wenn sie zur Feldregelung benutzt wird, erheblich verschlechtern. Eine Analyse des Problems für Hallkristalle mit negativem Temperaturkoeffizienten der Hallkonstante, wie er bei praktisch allen käuflichen Hallkristallen auftritt, zeigt, daß für einen thermostatisierten Probenkopf herkömmlichen Aufbaues die Regelanordnung instabil sein sollte (thermische Mitkopplung) gegenüber auch differentiellen Feldstörungen. Hinzu kommt, daß beim schnellen Durchlaufen großer Feldbereiche unerwünschte, thermisch verursachte Einschwingvorgänge auftreten, wenn die Durchlaufzeiten kurz verglichen mit den thermischen Zeitkonstanten eines derartigen Probenkopfes sind.

Man hat daher versucht, die Verlustleitung des Hallkristalls dadurch zu stabilisieren, daß man die Verlustleistung über eine Strom/Spannungsmessung durch Multiplikation dieser beiden Meßgrößen ermittelt und nachgeregelt hat. Der hierzu erforderliche Aufwand für die Meßwerterfassung, die Analogmultiplizierer und eine entsprechende Regeleinheit ist jedoch beträchtlich und hat in den bekannten Einrichtungen bei vertretbarem Regelungsaufwand immer noch zu einem Fehler von etwa $\pm 5 \%$ geführt.

Bei dem aus der eingangs genannten DE-Z A.T.M. bekannten Verfahren bzw. bei der dort beschriebenen Schaltung zur Versorgung eines Hallkristalls wird zwar beschrieben, daß für genaue Messungen sowohl die Temperaturabhängigkeit des Hallkristalls wie auch dessen Unlinearität zwischen Feld und Hallspannung berücksichtigt werden muß, bei der dort beschriebenen Schaltung wird jedoch lediglich ein Vorwiderstand zur Versorgung des Hallkristalls aus einer Spannungsquelle verwendet, der durch eine Transistorschaltung ergänzt wird, so daß sich die Stabilisierung des Hallkristalls auf eine reine Stromstabilisierung beschränkt. Hinsichtlich der Dimensionierung des Vorwiderstandes ist nur angegeben, daß er groß gegenüber einem nicht weiter definierten anderen Widerstand gebildet werden muß. Durch zusätzliche Verwendung von temperaturabhängigen Elementen vermag die bekannte Schaltung also nur Temperaturschwankungen und Netzschwankungen in der Versorgung der Stromquelle zu kompensieren.

Der Erfindung liegt demgegenüber die Aufgabe zugrunde, ein Verfahren und eine Vorrichtung der eingangs genannten Art dahingehend weiterzubilden, daß die Verlustleistung des Hallkristalls über einen weiten Bereich durch einfache schaltungstechnische Maßnahmen so eingestellt und damit stabilisiert wird, daß sie nur in einem vernachlässigbaren Bereich variiert.

Diese Aufgabe wird nach dem eingangs genannten Verfahren dadurch gelöst, daß die Abhängigkeit des normierten Wertes des Widerstandes des Hallkristalls von der Stärke des magnetischen Feldes in dessen interessierendem Arbeitsbereich formelmäßig ermittelt wird, daß unter Berücksichtigung dieser Abhängigkeit die Abhängigkeit der Variation der Verlustleistung im Hallkristall von der Stärke der magnetischen Feldes in dessen interessierendem Arbeitsbereich unter Parametrierung von $\varepsilon = \frac{Z}{R_0}$, d. h. Verhältnisses des Wertes des Vorwiderstandes und des Wertes des Innenwiderstandes des Hallkristalls bei einem magnetischen Feld der Stärke Null, ermittelt wird, daß ferner der Wert des Vorwiderstandes für minimale Variation der Verlustleistung optimiert wird und daß schließlich der Hallkristall in Reihe mit einem Vorwiderstand dieses optimalen Wertes aus einer Konstantspannungsquelle betrieben wird.

Gemäß der eingangs genannten Vorrichtung wird die Aufgabe bei einem Hallkristall, der in Reihe mit einem Vorwiderstand parallel zu einer Konstantspannungsquelle liegt, dadurch gelöst, daß der Vorwiderstand nach dem vorstehend genannten Verfahren gewählt ist.

Das erfindungsgemäße Verfahren und die erfindungsgemäße Vorrichtung haben damit den wesentlichen Vorteil, daß der Steuerstrom für den Hallkristall durch einfache und geschickte Dimensionierung des Ansteuerkreises so eingestellt wird, daß sich nur eine minimale Variation der Verlustleistung über den interessierenden Arbeitsbereich ergibt. Diese Variation ist so gering, daß die daraus entstehende Temperaturvariation des Hallkristalls noch hingenommen werden kann. Weiterhin hat die Erfindung den Vorteil, daß sie für verschiedenste Hallkristalle Verwendung finden kann, weil die genannte einfache Dimensionierung des Ansteuerkreises auf die jeweils tatsächlich vorliegende Charakteristik des Hallkristalls optimiert werden kann. Damit kann je nach vorliegender Charakteristik des Hallkristalls entweder bei einer Serienfertigung jedes einzelne Gerät entsprechend optimiert und betrieben werden, oder bei ausreichend geringer Streuung genügt es, das Verfahren nur einmal durchzuführen.

Gemäß einer Weiterbildung des erfindungsgemäßen Verfahrens wird zur Optimierung des Wertes des Vorwiderstandes die Abhängigkeit des Widerstandswertes des Hallkristalls von der Stärke des magnetischen Feldes als Funktion der Gestalt:

$$y = 1 + ax^2 / (b + x)$$

angenommen.

Diese Maßnahme hat den Vorteil, daß die Optimierung besonders einfach vorgenommen werden kann, wenn die beiden Kennwerte a und b des jeweils vorliegenden Hallkristalls bekannt sind.

Beispielsweise ergibt sich eine besonders gute Optimierung dann, wenn a = 0,592 und b = 0,692 ist und hieraus ein optimales Verhältnis des Vorwiderstandswertes zum Widerstandswert des Hallkristalls bei einer Stärke des magnetischen Feldes gleich Null von etwa 1,4 eingestellt wird.

Weitere Vorteile ergeben sich aus der Beschreibung und der beigefügten Zeichnung.

Die Erfindung ist in der Zeichnung dargestellt und wird in der nachfolgenden Beschreibung näher erläutert.

Es zeigen:

Fig. 1 eine Prinzipdarstellung einer Anordnung zum Regeln der Stärke eines magnetischen Feldes;

Fig. 2 ein Diagramm zur Veranschaulichung der Abhängigkeit des Innenwiderstandes eines Hallkristalles von der Stärke des magnetischen Feldes;

Fig. 3 eine Ersatzfunktion für den Verlauf gemäß Fig. 2;

Fig. 4 ein prinzipielles Schaltbild zur Versorgung und Stabilisierung eines Hallkristalls;

Fig. 5 verschiedene Diagramme zur Erläuterung der Optimierung im Rahmen der vorliegenden Erfindung;

Fig. 6 ein Prinzipschaltbild einer erfindungsgemäß optimierten Versorgungsschaltung eines Hallkristalls;

Fig. 7 Verläufe der normierten Spannung und des normierten Stromes bei einer Stabilisierung eines Hallkristalls gemäß der vorliegenden Erfindung.

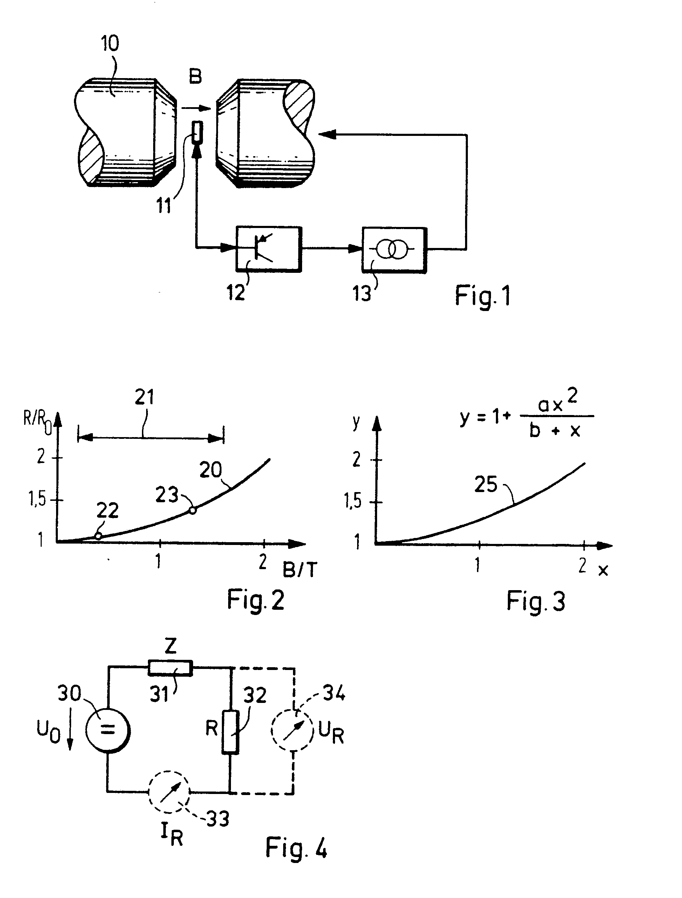

Fig. 1 zeigt im Prinzip eine Feldregelung für einen Elektromagneten, wie er beispielsweise bei Elektronenspinresonanz-Spektrometern, bei Werkstoffuntersuchungen der verschiedensten Art u.dgl. verwendet wird.

Mit 10 ist dabei ein Elektromagnet angedeutet, in dessen Luftspalt sich eine Sonde mit einem Hallkristall 11 befindet. Die Eigenschaften des Hallkristalls 11 ändern sich in der eingangs beschriebenen Weise in Abhängigkeit von der Stärke B des im Luftspalt herrschenden Magnetfeldes. Der Hallkristall 11 ist an ein Versorgungs- und Regelgerät 12 angeschlossen, das einerseits die Versorgungsspannung bzw. den Versorgungsstrom für den Hallkristall 11 erzeugt, andererseits aber auch die Hallspannung mißt und daraus ein für die Stärke B des Magnetfeldes charakteristisches Signal ableitet. Dieses Signal wird einem Netzgerät 13 zugeleitet, das zur geregelten Stromversorgung des Magneten 10 dient.

In Fig. 2 ist die Feldabhängigkeit des Innenwiderstandes des Hallkristalls 11 in normierter Form dargestellt. Mit R ist dabei der tatsächliche Wert des Innenwiderstandes bezeichnet und mit $R_0$ derjenige Wert, der dem Feldwert Null zugeordnet ist.

Man erkennt, daß sich der normierte Innenwiderstand $R/R_0$ über der Stärke B des Magnetfeldes überproportional entlang eines Verlaufes 20 erhöht. Mit 21 ist ein typischer Arbeitsbereich für Elektronenspinresonanz-Experimente bezeichnet, in dem ein erster Arbeitspunkt 22 und ein zweiter Arbeitspunkt 23 liegen. Der erste Arbeitspunkt 22 entspricht beispielsweise einem Wert, bei dem Experimente im X-Band der Mikrowelleneinheit eines Elektronenspinresonanz-Spektrometers durchgeführt werden, während der zweite Arbeitspunkt 23 bei Experimenten im Q-Band eingestellt wird, wie dies an sich bekannt ist.

Es versteht sich, daß diese Zahlenangaben nur beispielhaft zu verstehen sind und daß selbstverständlich auch Experimente in anderen Feldbereichen, beispielsweise bis über 2,5 Tesla hinaus und bis hinunter zu einem Feldwert Null möglich sind.

Fig. 2 zeigt die Abhängigkeit des normierten Innenwiderstandes von der Stärke des magnetischen Feldes für einen bestimmten Hallkristall. Es hat sich jedoch gezeigt, daß die Verläufe 20 in guter Näherung durch Verläufe 25 angenähert werden können, wie sie in Fig. 3 dargestellt sind. Dem Verlauf 25 in Fig. 3 liegt die Funktion:.

$$y = 1 + ax^2 / (b + x)$$

zugrunde. Die Koeffizienten a und b sind Materialkonstanten. Bei einem typischen Hallkristall liegen z. B. die folgenden Werte vor:
a = 0,592
b = 0,692.

Fig. 4 zeigt als Prinzipdarstellung eine Versorgungsschaltung für einen Hallkristall. Mit 30 ist dabei eine Konstantspannungsquelle der Spannung U bezeichnet und mit 31 ein Vorwiderstand oder Innenwiderstand des Betrages Z. Mit 32 ist der Innenwiderstand R des Hallkristalls 11 charakterisiert.

Man hat nun versucht, die Verlustleistung im Hallkristall, d. h. die im Widerstand 32 umgesetzte Verlustleistung dadurch zu erfassen, daß man den Strom $I_R$ durch den Widerstand 32 über einen Strommesser 33 und die über dem Widerstand 32 abfallende Spannung $U_R$ über einen Spannungsmesser 34 erfaßt. Die Größen $I_R$ und $U_R$ mußten hierzu jedoch präzise ermittelt und analog multipliziert werden, insgesamt war damit ein erheblicher Schaltungsaufwand verbunden.

Erfindungsgemäß ist demgegenüber vorgesehen, statt des erheblichen Aufwandes für das Erfassen, Ermitteln und Regeln der Verlustleistung eine geeignete Dimensionierung des Ansteuerkreises vorzunehmen, so daß unter Berücksichtigung der Feldabhängigkeit des Innenwiderstandes des Hallkristalls eine nur geringe Variation der Verlustleistung im Hallkristall auftritt.

Hierzu definiert man die Variation mit:

$$\delta P = \frac{P(B) - P(O)}{P(O)}$$

Dabei bedeutet δP die Variation der Verlustleistung, P(B) die Verlustleistung bei einem Wert B der magnetischen Feldstärke und P(O) die Verlustleistung bei einem Feld gleich Null.

Man kann nun zeigen, daß die Variation der Verlustleistung in Abhängigkeit von der Variation des Innenwiderstandes des Hallkristalls die folgende Form hat:

$$\delta P = \frac{R/R_0 (\varepsilon + 1)^2}{(\varepsilon + R/R_0)^2} - 1.$$

Dabei ist $R/R_0$ wiederum der normierte Innenwiderstand des Hallkristalls 11 und $\varepsilon = Z/R_0$, d. h. das Verhältnis der Werte von Vorwiderstand 31 und Innenwiderstand 32 des Hallkristalls 11 beim Feld Null.

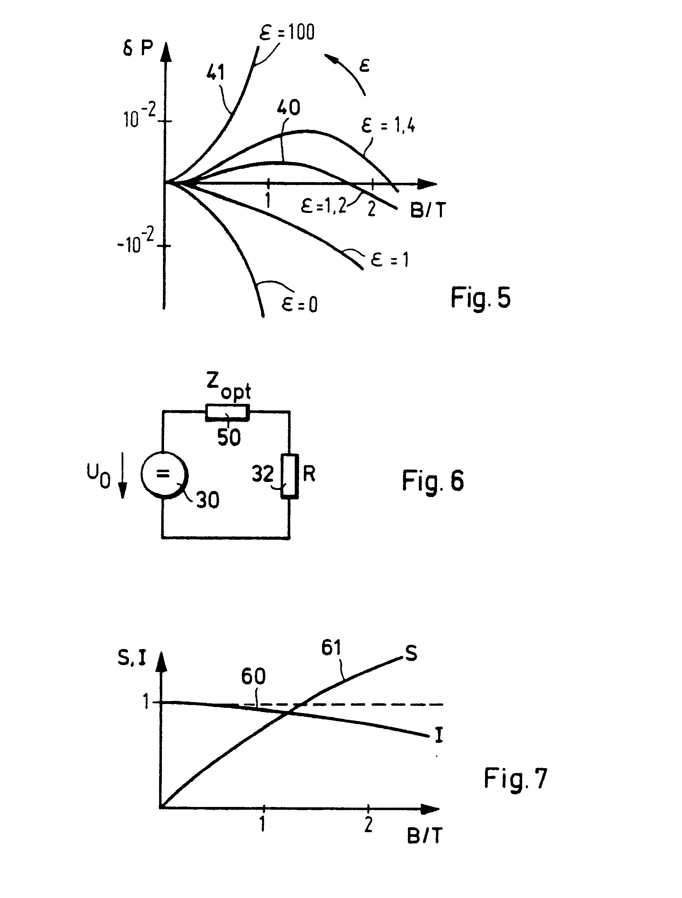

Unter Berücksichtigung der experimentell ermittelten oder durch eine Funktion angenäherten Abhängigkeit des normierten Innenwiderstandes $R/R_0$ von der Stärke B des magnetischen Feldes ergeben sich unter Parametrierung von ε die in Fig. 5 dargestellten Verläufe.

Man erkennt, daß für einen Verlauf 40 bei einem Parameter von ε = 1,4 ein optimaler Verlauf vorliegt, bei dem die Variation der Verlustleistung δP nur wenige Prozent beträgt. Verglichen mit einem üblichen Parameter ε = 100 für bekannte Anordnungen stellt dies eine wesentliche Verbesserung dar, weil die Variation der Verlustleistung δP bei den bekannten Anordnungen, wie eingangs erwähnt, im Bereich zwischen 50 % und mehreren 100 % liegt.

Der ermittelte optimale Parameter ε = 1,4 gestattet nun, den Vorwiderstand 31 so zu optimieren, daß ein optimaler Vorwiderstand 50 mit einem Wert $Z_{opt}$ eingeschaltet wird, bei dem die Variation der Verlustleistung δP des Innenwiderstandes 32 des Hallkristalls 11 minimal ist, wie aus Fig. 6 ersichtlich.

Der Ausgangswiderstand R(O) des Hallkristalls 11 beträgt beispielsweise 1,7Ω, so daß für das vorgenannte Beispiel der optimale Vorwiderstand einen Wert $Z_{opt}$ von 2,38Ω erhält. Für diesen optimierten Wert ergibt sich dann die Variation der Verlustleistung δP entsprechend dem Verlauf 40 von Fig. 5, bei dem die Variation nur wenige Prozent beträgt.

Fig. 7 zeigt schließlich noch in Abhängigkeit von der Stärke B des magnetischen Feldes einen Verlauf 60 für den normierten Strom I durch den Hallkristall 11 und einen Verlauf 61 für das Signal S bzw. die normierte Spannung am Hallkristall 11, jeweils für den optimierten Parameter ε = 1,4.

Die absolute Größe des Steuerstromes kann nun frei gewählt werden, vorzugsweise wird sie so eingestellt, daß die vom Hersteller des Hallkristalls angegebene maximale Sondenverlustleistung voll ausgenutzt wird, um ein möglichst großes Hallsignal zu erhalten.

Insgesamt ergab sich für das bereits mehrfach erwähnte Ausführungsbeispiel mit R(O) = 1,7Ω, a = 0,592, b = 0,692 und dem optimierten Parameter ε = 1,4 bei 37 untersuchten Hallkristallen eine Verwendungswahrscheinlichkeit von über 95 % bei einem Betrag der Variation der Verlustleistung δP von weniger als 4 % über einen Feldbereich von 2,5 Tesla.

**Patentansprüche**

1. Verfahren zum Stabilisieren des Arbeitspunktes eines in einem Magnetfeld variabler Stärke (B) befindlichen und aus einer Versorgungsquelle (12) mit elektrischer Energie versorgten Hall-Kristalls (11), bei dem der Hallkristall (11) über einen Vorwiderstand (31) aus einer Konstantspannungsquelle (30) versorgt und die Verlustleistung (P) des Hallkristalls ermittelt und stabilisiert wird, dadurch gekennzeichnet, daß die Abhängigkeit des normierten Wertes $(R/R_o)$ des Widerstandes (32) des Hallkristalls (11) von der Stärke (B) des magnetischen Feldes in dessen interessierendem Arbeitsbereich (21) formelmäßig ermittelt wird, daß unter Berücksichtigung dieser Abhängigkeit die Abhängigkeit der Variation der Verlustleistung (δP) im Hallkristall (11) von der Stärke (B) des magnetischen Feldes in dessen interessierendem Arbeitsbereich (21) unter Parametrierung von $\varepsilon = \frac{Z}{R_o}$, d. h. des Verhältnisses des Wertes (Z) des Vorwiderstandes (31) und des Wertes $(R_o)$ des Innwiderstandes (32) des Hallkristalls (11) bei einem magnetischen Feld der Stärke Null, ermittelt wird, daß ferner der Wert (Z) des Vorwiderstandes (31) für minimale Variation der Verlustleistung (δP) optimiert wird und daß schließlich der Hallkristall (11) in Reihe mit einem Vorwiderstand (50) dieses optimierten Wertes $(Z_{opt})$ aus der Konstantspannungsquelle (30) betrieben wird.

2. Verfahren nach Anspruch 1, dadurch gekennzeichnet, daß zur Optimierung des Wertes (Z) des Vorwiderstandes (31) die Abhängigkeit des normierten Widerstandswertes $(R/R_o)$ des Hallkristalls (11) von der Stärke (B) des magnetischen Feldes als Funktion der Gestalt:

$$y = 1 + ax^2/ (b + x)$$

angenommen wird, wobei a und b Materialkonstanten des Hallkristalls (11) sind.

3. Verfahren nach Anspruch 2, dadurch gekennzeichnet, daß für a = 0,592 und b = 0,692 das Verhältnis (ε) des Vorwiderstandswertes (Z) zu dem Widerstandswert $(R_o)$ des Hallkristalls (11) bei einem magnetischen Feld der Stärke Null die Größe von etwa 1,4 hat.

4. Verfahren nach einem der Ansprüche 1 bis 3, dadurch gekennzeichnet, daß die absolute Größe des Stromes $(I_R)$ durch den Hallkristall (11) so eingestellt wird, daß die spezifizierte maximal zulässige Verlustleistung ausgenutzt wird.

5. Vorrichtung zum Stabilisieren des Arbeitspunktes eines in einem Magnetfeld variabler Stärke (B) befindlichen und aus einer Versorgungsquelle (12) mit elektrischer Energie versorgten Hallkristalls (11), bei der der Hallkristall (11) in Reihe mit einem Vorwiderstand (50) parallel zu einer Konstantspannungsquelle (30) liegt, dadurch gekennzeichnet, daß der Vorwiderstand (50) nach einem Verfahren gemäß einem der Ansprüche 1 bis 4 gewählt ist.

**Claims**

1. Method for stabilizing the operating point of a Hall crystal (11) which is located in a magnetic field of variable strength (B) and is supplied with electrical energy from a supply source (12), in which the Hall crystal (11) is supplied via a series resistance (31) from a constant voltage source (30) and the power loss (P) of the Hall crystal is determined and stabilized, characterized in that the dependence of the normalized value $(R/R_o)$ of the resistance (32) of the Hall crystal (11) on the strength (B) of the magnetic field in its operating range (21) of interest is determined as a formula, that, taking into consideration this dependence, the dependence of the variation of the power loss ( P) in the Hall crystal (11) on the strength (B) of the magnetic field in its operating range (21) of interest is determined with parameterization of $\varepsilon = \frac{Z}{R_o}$, that is to say of the ratio of the value (Z) of the series resistance (31) and of the value $(R_o)$ of the internal resistance (32) of the Hall crystal (11) with a magnetic field of strength zero, that furthermore the value (Z) of the series resistance (31) is optimized for minimum variation of the power loss (P) and that, finally, the Hall crystal (11) is operated in series with a series resistance (50) of this optimized value $(Z_{opt})$ from the constant voltage source (30).

2. Method according to Claim 1, characterized in that, for optimizing the value (Z) of the series resistance (31), the dependence of the normalized resistance value $(R/R_o)$ of the Hall crystal (11) on the strength (B) of the magnetic field is assumed as function having the form:

$$y = 1 + ax^2/ (b + x)$$

where a and b are matter constants of the Hall crystal (11).

3. Method according to Claim 2, characterized in that for a = 0.592 and b = 0.692, the ratio (ε) of the series resistance value (Z) to the resistance value $(R_o)$ of the Hall crystal (11) has the magnitude of about 1.4 with a magnetic field of strength zero.

4. Method according to one of Claims 1 to 3, characterized in that the absolute magnitude of the current $(I_R)$ through the Hall crystal (11) is set such that the specified maximum permissible power loss is utilized.

5. Device for stabilizing the operating point of a Hall crystal (11) which is located in a magnetic field of variable strength (B) and is supplied with electrical energy from a supply source (12), in which the Hall crystal (11) is located in series with a series resistance (50) parallel with a constant voltage source (30), characterized in that the series resistance (50) is selected in accordance with a method according to one of Claims 1 to 4.

## Revendications

1. Procédé de stabilisation du point de fonctionnement d'un cristal à effet Hall (11) situé dans un champ magnétique d'intensité variable (B) et alimenté en énergie électrique par une source (12), dans lequel une source de tension constante (30) alimente le cristal à effet Hall (11) par l'intermédiaire d'une résistance additionnelle (31) et la dissipation du cristal à effet Hall est déterminée et stabilisée, ledit procédé étant caractérisé en ce que la variation de la valeur normée ($R/R_o$) de la résistance (32) du cristal à effet Hall (11) est déterminée en fonction de l'intensité (B) du champ magnétique, sur sa plage de fonctionnement intéressante, sous forme d'une formule; compte tenu de ladite variation, la variation de la dissipation ($\delta P$) du cristal à effet Hall (11) est déterminée en fonction de l'intensité (B) du champ magnétique sur sa plage de fonctionnement (21) intéressante, par paramétrisation de $\varepsilon = Z/R_o$, c'est-à-dire du rapport de la valeur (Z) de la résistance additionnelle (31) à la valeur ($R_o$) de la résistance interne du cristal à effet Hall (11) pour un champ magnétique d'intensité nulle; la valeur (Z) de la résistance additionnelle (31) est optimisée pour une variation minimale de la dissipation ($\delta P$); et enfin le cristal à effet Hall (11) est, en série avec une résistance additionnelle (50) présentant ladite valeur optimisée ($Z_{opt}$), alimenté par la source de tension constante (30).

2. Procédé selon revendication 1, caractérisé en ce que pour l'optimisation de la valeur (Z) de la résistance additionnelle (31) une fonction de la forme:

$$y = 1 + ax^2 / (b + x)$$

est adoptée pour la variation de la valeur normée ($R/R_o$) de la résistance du cristal à effet Hall (11) en fonction de l'intensité (B) du champ magnétique, a et b étant des constantes du matériau du cristal à effet Hall (11).

3. Procédé selon revendication 2, caractérisé en ce que pour a = 0,592 et b = 0,692, le rapport ($\varepsilon$) de la valeur (Z) de la résistance additionnelle à la valeur ($R_o$) de la résistance du cristal à effet Hall (11) pour un champ magnétique d'intensité nulle présente une valeur d'environ 1,4.

4. Procédé selon une quelconque des revendications 1 à 3, caractérisé en ce que la valeur absolue du courant ($I_R$) dans le cristal à effet Hall (11) est ajustée de façon à permettre l'utilisation de la dissipation maximale admissible spécifiée.

5. Dispositif de stabilisation du point de fonctionnement d'un cristal à effet Hall (11) situé dans un champ magnétique d'intensité variable (B) et alimenté en énergie électrique par une source (12), dans lequel le cristal à effet Hall (11) est, en série avec une résistance additionnelle (50) en parallèle avec une source de tension constante (30), ledit procédé étant caractérisé par le choix de la résistance additionnelle (50) selon un procédé selon une quelconque des revendications 1 à 4.

Fig.1

$$y = 1 + \frac{a x^2}{b + x}$$

Fig.2

Fig.3

Fig. 4

Fig. 5

Fig. 6

Fig. 7